(19) Europäisches Patentamt / European Patent Office / Office européen des brevets

(11) **EP 2 428 876 A2**

(12) **EUROPEAN PATENT APPLICATION**

(43) Date of publication:
**14.03.2012 Bulletin 2012/11**

(51) Int Cl.:
***G06F 3/033*** (2006.01)

(21) Application number: **11250677.9**

(22) Date of filing: **27.07.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **10.09.2010 JP 2010202569**

(71) Applicant: **Hosiden Corporation
Yao-shi, Osaka 581-0071 (JP)**

(72) Inventors:
• **Toyota, Naoki
  Yao-Shi, Osaka 581-0071 (JP)**
• **Miyaura, Nobumasa
  Yao-Shi, Osaka 581-0071 (JP)**
• **Nakagawa, Hiroshi
  Yao-Shi, Osaka 581-0071 (JP)**

(74) Representative: **Beresford, Keith Denis Lewis et al
Beresford & Co.
16 High Holborn
London
WC1V 6BX (GB)**

(54) **Multidirectional input device**

(57)    The invention provides a multidirectional input device capable of reducing power consumption in a sleep mode period. A multidirectional input device PD includes an input unit 100 and a capacitance detection IC 200. The input unit 100 includes an operation body 120, a metal piece 130 movable in multiple directions, and various electrodes 141a to 144a, 140b and 150 disposed on a surface of an insulating substrate 110. The capacitance detection IC 200 detects the presence or absence of movement of the operation body 120 through measurement of capacitance between the metal piece 130 and the detection electrode 140b, while it detects a movement direction of the operation body 120 through measurements of capacitances between the metal piece 130 and the respective detection electrodes 141a to 144a. A distance R1 and a distance R2 are substantially the same, where R1 is a planar distance between an outer circumference of an outer peripheral area 132 of the metal piece 130 and inner circumferences of the detection electrodes 141a to 144a at an initial position, and R2 is a planar distance between an inner circumference of the outer peripheral area 132 and an outer circumference of the GND electrode 150.

FIG. 1A

EP 2 428 876 A2

**Description**

Technical Field

The present invention relates to capacitance-type multidirectional input devices for detecting directions of operation of operation levers.

Background Art

This type of multidirectional input devices has been widely utilized as pointing devices, joysticks or the like in various types of electronic equipment such as mobile telephone sets and game machines. A conventional device as disclosed in JP 2001-325858, by way of example, includes an operation lever operable in multiple directions, a substrate populated with a plurality of fixed electrodes, and a movable electrode disposed in the operation lever to face the fixed electrodes. The operation of the operation lever changes the sizes of facing areas of the plurality of fixed electrodes and the movable electrode, accordingly the changes in capacitance between the two kinds of electrodes are measured to detect the direction in which the operation lever is operated.

Summary of Invention

For the purpose of reducing overall power consumption of the input device, the device enters a sleep mode (processes as an operation input waiting state) when the operation lever is not operated for a predetermined period. That is, the device in the sleep mode detects whether the operation lever has moved, and upon detecting a movement of the operation lever, the device switches the sleep mode to an active mode (processes as a continuous detecting state), in which state the device continuously detects the operating direction of the operation lever.

However, in order to detect in the sleep mode whether or not the operation lever has moved, it is requisite to pass a drive current sequentially to the plurality of fixed electrodes. This requisite has been noted as a hurdle in reducing power consumption. Especially in battery-driven portable equipment, the input device is in wait for an input from a user most of the time, so that there is demand for decrease in current consumption in the sleep mode period to extend battery run-time.

The present invention is devised in view of the above-described background. The present invention provides a multidirectional input device capable of reducing power consumption in a sleep mode period.

A multidirectional input device according to the present invention includes a base having a surface; a plurality of first detection electrodes, spacedly arranged in an annular shape on the surface of the base; an second detection electrode of annular shape, disposed concentrically with the first detection electrodes and inside the first detection electrodes on the surface of the base; a GND electrode, disposed concentrically with the second detection electrode and inside the second detection electrode on the surface of the base; an operation portion, facing the base and being movable in multiple directions from a predetermined original position; a movable metal member of annular shape, movable from an initial position, where the movable metal member faces the second detection electrode, in accordance with movement of the operation portion; and a detection device, adapted to detect presence or absence of movement of the operation portion through measurement of capacitance between the movable metal member and the second detection electrode, and adapted to detect a movement direction of the operation portion through measurements of capacitances between the movable metal member and the respective first detection electrodes. A distance R1 and a distance R2 are substantially the same, where R1 is a planar distance between an outer end of the movable metal member located at the initial position and inner ends of the first detection electrodes, and R2 is a planar distance between an inner end of the movable metal member located at the initial position and an outer end of the GND electrode.

This aspect of the invention makes it possible to detect the presence or absence of movement of the operation portion by measuring the capacitances between the movable metal member and the second detection electrode, advantageously obviating the need to pass a drive current through the plurality of the first detection electrodes for detecting the presence or absence of the movement of the operation portion. The invention thus contributes reduction in power consumption in detecting the presence or absence of movement of the operation portion (that is, in the sleep mode). In addition, as the distance R1 and the distance R2 are substantially the same, when the movable metal member moves in accordance with the movement of the operation portion, the movable metal member virtually simultaneously crosses in plane position the first detection electrode on the movement direction side and the GND electrode, increasing the capacitance produced between the movable metal member and the first detection electrode on the movement direction side. Consequently, the invention can improve detection accuracy of the movement of the operation portion and achieve a higher performance of the input device. Furthermore, as the movable metal member and the second detection electrode face each other at the initial position and the presence or absence of movement of the operation portion can be detected by applying a voltage to the second detection electrode only once, the invention can shorten time required for detecting the presence or absence of movement of the operation portion, achieving higher performance of the input device.

The detection device may include a switcher that selects one detection electrode from the first and second detection electrodes; a detector that detects a magnitude of the capacitance between the detection electrode selected by the switcher and the movable metal member; and a controller that controls the switcher to switch between a sleep mode to detect presence or absence of the movement of the operation portion and an active mode to detect the movement direction of the operation portion. In this case, the controller may control the switcher so as to select the second detection electrode and thereby set the sleep mode, and in this state, the controller may detect the presence or absence of the movement of the operation portion based on output from the detector, and thereafter, upon detection of the movement of the operation portion, the controller may control the switcher so as to sequentially select the first detection electrodes and thereby switch the sleep mode to the active mode, and in this state, the controller may detect the movement direction of the operation portion based on output of the detector, and thereafter, when observing no change in the movement direction of the operation portion for a predetermined period, the controller may control the switcher so as to select the second detection electrode and thereby switch the active mode to the sleep mode.

Alternatively, the detection device may include a switcher that selects either the first electrodes or the second detection electrode; a detector that detects a magnitude of the capacitance between the detection electrode or electrodes selected by the switcher and the movable metal member; and a controller that controls the switcher to switch between a sleep mode to detect the presence or absence of the movement of the operation portion and an active mode to detect the movement direction of the operation portion. In this case, the controller may control the switcher so as to select the second detection electrode and thereby set the sleep mode, and in this state, the controller may detect the presence or absence of the movement of the operation portion based on output from the detector, and thereafter, upon detection of the movement of the operation portion, the controller may control the switcher so as to select the first detection electrodes and thereby switch the sleep mode to the active mode, and in this state, the controller may detect the movement direction of the operation portion based on output of the detector, and thereafter, when observing no change in the movement direction of the operation portion for a predetermined period, the controller may control the switcher so as to select the second detection electrode and thereby switch the active mode to the sleep mode.

It is preferable that the switcher connect the selected detection electrode or electrodes to the detector and the unselected detection electrode or electrodes to GND. According to this aspect of the invention, there exists no detection electrodes electrically floating between the selected detection electrode and the GND electrode. When the movable metal member moves in accordance with the movement of the operation portion and crosses the selected detection electrode, the GND electrode, and the unselected detection electrodes in plane position, a large potential difference is generated via the movable metal member between the selected detection electrode and the GND (that is, the GND electrode and the unselected detection electrodes). It is thus possible to further increase the capacitance generated between the movable metal member and the first detection electrode on the movement direction side, thereby enhancing the detection accuracy of the movement of the operation portion and achieving the higher performance of the device.

It is preferable that upon receiving an external command in the active mode, the detection device control the switcher so as to select the second detection electrode and thereby switch to the sleep mode. This aspect of the invention makes it possible to effect an forced shift to the sleep mode through the external command when it becomes unnecessary to detect the operating direction of the operation portion in the active mode. Power consumption can be further reduced in this respect.

It is preferable that the multidirectional input device further include an insulating layer provided on the surface of the base so as to cover at least the first and second detection electrodes, wherein the movable metal member is partly contactable with an outer surface of the insulating layer. According to this aspect of the invention, the insulating layer serves to protect the first and second detection electrodes to increase mechanical strength. Also, the capacitances between the movable metal member and the first and second detection electrodes is increased, accordingly improving sensitivity.

It is preferable that the multidirectional input device further include a press switch that detects a press of the operation portion. The press switch may include a dome-like snap plate, fixedly sandwiched between the base and the insulating layer and adapted to be turned inside out when the operation portion is pressed; and contact electrodes disposed on the surface of the base, and closed by the snap plate turned inside out.

This aspect of the invention can ease fixing work of the snap plate because the snap plate is fixedly sandwiched between the base and the insulating layer. Moreover, the insulating later protects the snap plate, thereby improving its mechanical strength.

It is preferable that the operation portion include a shaft having an end, the end being adapted to face the press switch at the original position, and an annular flange provided around a circumferential surface of the end of the shaft. In this aspect of the invention, when the operation portion is displaced from the original position and pressed, the annular flange can press the press switch. That is, this aspect of the invention allows the operation portion during movement operations to perform pressing operation input, resulting in higher performance of the input device.

Brief Description of Drawings

Figs. 1A and 1B are vertical cross-sectional views of a multidirectional input device according to an embodiment of the present invention, wherein Fig. 1A shows a state where an operation portion is located at an original position, and Fig. 1B shows a state where the operation portion has moved from the original position.

Fig. 2 is a schematic exploded perspective view of the device.

Figs. 3A and 3B are schematic plan views illustrating an arrangement of various electrodes formed on an insulating substrate of the device, wherein Fig. 3A shows a state where a metal member is located at an initial position, and Fig. 3B shows a state where the metal member has moved from the initial position.

Fig. 4 is a block diagram illustrating the configuration of the device.

Fig. 5 explains relationships between a detection electrode connected to a capacitance detection logic and the detection electrodes connected to the GND by a multiplexer of the device.

Fig. 6 is a flowchart providing an overview of a control program processed by a control logic of a capacitance detection IC of the device.

Fig. 7 is a view showing changes in power consumption over periods of sleep and active modes of the device.

Description of Embodiments

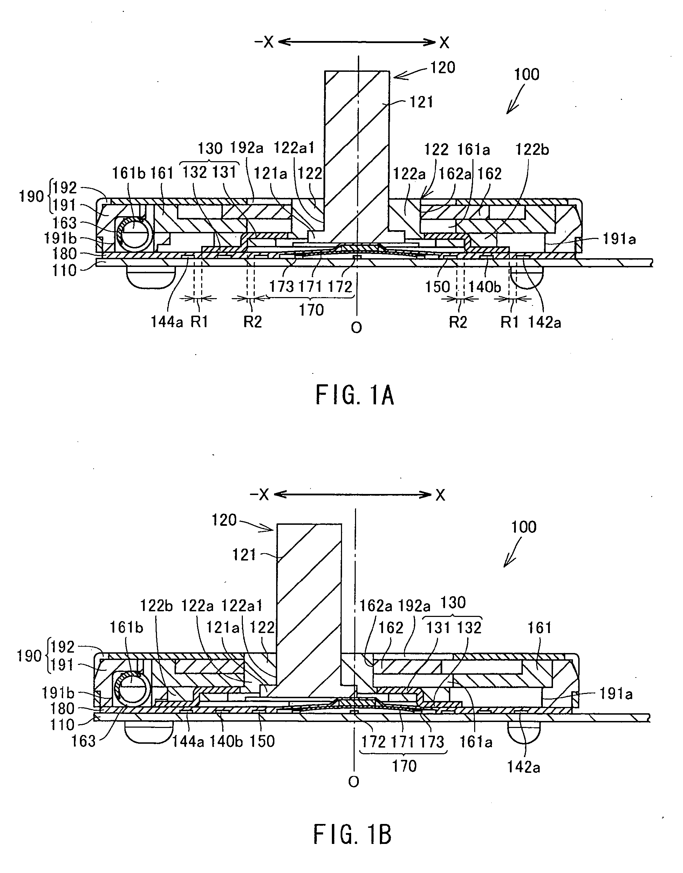

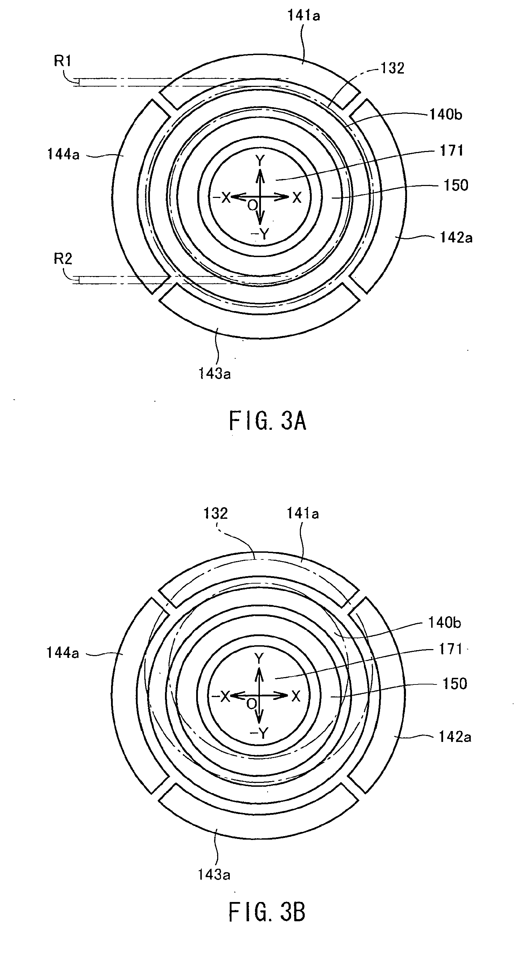

Hereinafter, a multidirectional input device according to an embodiment of the present invention will be described with referent to Figs. 1A to 7. The multidirectional input device exemplified herein is a capacitance-type pointing device PD to be installed in a mobile telephone, a game instrument or the like. The pointing device PD includes an input unit 100 and a capacitance detection IC 200. As shown in Figs. 1A and 1B, the input unit 100 is adapted for two kinds of input operations. Particularly, an operation body 120 of the input unit 100 can be slid in multiple directions (any peripheral directions) from an original position O over an insulating substrate 110 and can also be pressed at the original position O toward the insulating substrate 110. As shown in Fig. 3A and 3B, the capacitance detection IC 200 (corresponding to a detection device) converts operation inputs in the input unit 100 to electric signals and output them to a host controller HC incorporated in the mobile telephone or the like. The respective elements of the input device will be described in detail below.

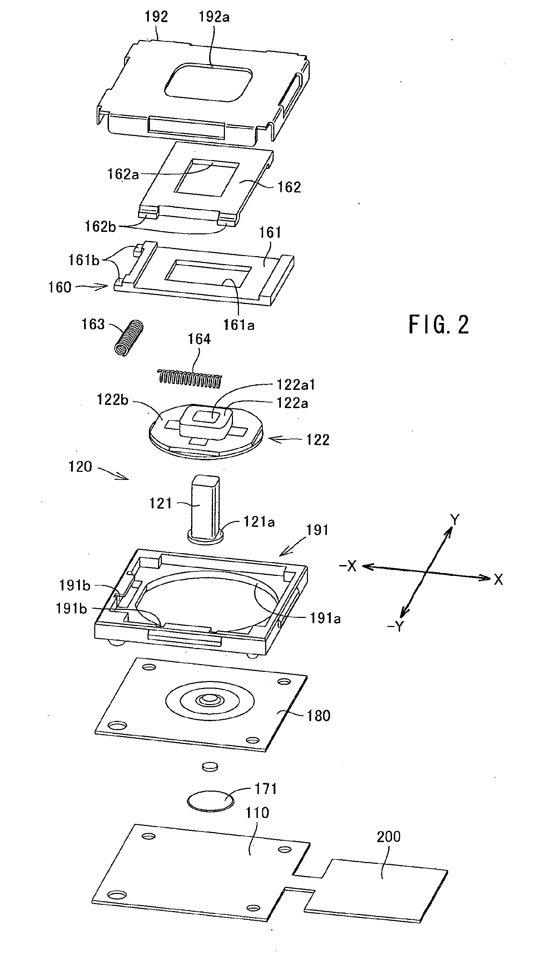

As shown in Figs. 1A, 1B and Fig. 2, the input unit 100 has the insulating substrate 110 (corresponding to a base), the operation body 120 (corresponding to an operation portion), a metal piece 130 (corresponding to a movable metal member), direction detection electrodes 141a to 144a (corresponding to first detection electrodes), a movement detection electrode 140b (corresponding to a second detection electrode), a GND electrode 150, an origin return mechanism 160, a press switch 170, an insulating layer 180, and a case 190.

The insulating substrate 110 is a flexible substrate. As shown in Figs. 3A and 3B, a surface of the insulating substrate 110 is provided with the direction detection electrodes 141a to 144a, the movement detection electrode 140b, the GND electrode 150 and the press switch 170.

The direction detection electrodes 141a to 144a are four circular-arc electrodes arranged in a circular ring shape around the original position O on the surface of the insulating substrate 110, spaced apart from each other with a pitch of 90°. The movement detection electrode 140b is of annular ring shape and formed concentrically with and on the inside of the direction detection electrodes 141a to 144a on the surface of the insulating substrate 110. The center of the movement detection electrode 140b matches the original position O, and the outer diameter of the movement detection electrode 140b is smaller than the inner diameter of a virtual circle drawn along inner circumferences of the direction detection electrodes 141a to 144a. The GND electrode 150 is of circular ring shape and formed concentrically with and on the inside of the movement detection electrode 140b on the surface of the insulating substrate 110. The outer diameter of the GND electrode 150 is smaller than the inner diameter of the movement detection electrode 140b.

The press switch 170 has a dome-like snap plate 171 and contact electrodes 172, 173 as shown in Figs. 1A and 1B. The contact electrode 172 is a circular electrode formed at the original position O on the surface of the insulating substrate 110. The contact electrode 173 is an annular electrode formed concentrically with the GND electrode 150 and the contact electrode 172 and inside the GND electrode 150 on the surface of the insulating substrate 110. The snap plate 171 is disposed on the surface of the insulating substrate 110 such that its outer circumferential edge abuts the contact electrode 173 and its top faces the contact electrode 172. The snap plate 171 is securely sandwiched between the insulating substrate 110 and the insulating layer 180. The snap plate 171 can be turned inside out when pressed by the operation body 120. When the snap plate 171 is turned inside out so that its top comes into contact with the contact electrode 172, the contact electrodes 172, 173 are closed.

As described above, the surface of the insulating substrate 110 is formed with the direction detection electrodes 141a to 144a, the movement detection electrode 140b, the GND electrode 150 and the contact electrodes 172 173. In addition to these, there are formed detection lines for connection with the respective direction detection electrodes 141a to 144a, the movement detection electrode 140b and the contact electrodes 172, 173. Also formed is a GND line for connection with the GND electrode 150. The above detection lines and the GND line are electrically connected to the capacitance detection IC 200.

The insulating layer 180 is an insulating sheet fixed onto the surface of the insulating substrate 110 as shown in Figs. 1A, 1B and Fig. 2. The insulating layer 180 covers the snap plate 171, the direction detection electrodes 141a to 144a, the movement detection electrode 140b, and the GND electrode 150. A central portion of the insulating layer 180 can be recessed in accordance with a press of the operation body 120. The recessed central portion, together with the operation body 120, presses the snap plate 171.

As shown in Figs. 1A, 1B and Fig. 2, the case 190 has a housing 191 of plastic material and a cover 192 made of a metal plate. The housing body 191 is a square cylindrical body with a bottom, and the insulating layer 180 and the insulating substrate 110 are fixed to the bottom. A circular receiving hole 191a is formed in a central portion of the bottom of the housing body 191. Of four sides of the housing body 191, two sides making a right angle each have a spring receiving hole 191b of generally rectangular shape. The cover 192 has a rectangular top plate and four locking portions extending downward from respective four sides of the top plate. The locking portions are to be locked to locking projections that are formed on outer surfaces of the four sides of the housing body 191. The top plate covers an upper side of the housing body 191 and has a rectangular opening 192a in its central portion.

As shown in Figs. 1A, 1B and Fig. 2, the operation body 120 has a rectangular columnar shaft 121 of plastic material and a disk-shaped slider 122 of plastic material. The slider 122 is contained in the housing body 191. The slider 122 has a square tuboid protrusion 122a and a disk-shaped attachment portion 122b provided around the outer circumferential surface of the protrusion 122a. The protrusion 122a has a vertical through-hole 122a1 of generally rectangular shape. A lower end of the shaft 121 is fitted in the through-hole 122a1 of the slider 122 so as to be movable vertically, and it is contained in the housing body 191 together with the slider 122. The lower end of the shaft 121 and the attachment portion 122b of the slider 122 abut the insulating layer 180, such that the shaft 121 and the slider 122 is movable on the insulating layer 180, parallel to the insulating substrate 110, from the original position O in the multiple directions. An upper end of the protrusion 122a of the slider 122 is received in the opening 192a of the cover 192, thereby restricting a movement range of the operation body 120. An upper end of the shaft 121 projects from the opening 192a of the cover 192 and serves as a portion to be operated by a user. At the original position O, the lower end of the shaft 121 is located above the top of the snap plate 171 of the press switch 170, with the insulating layer 180 interposed therebetween (i.e., the lower end of the shaft 121 faces the snap plate 171 with the insulating layer 180 interposed therebetween). In other words, the lower end of the shaft 121 is adapted to press the snap plate 171 of the press switch 170 via the insulating layer 180. It should be noted that a disk-shaped flange 121a is provided along the outer circumference at the lower end of the shaft 121. The flange 121a is adapted to press the snap plate 171 of the press switch 170 with the insulating layer 180 interposed therebetween, even when the shaft 121 has moved from the original position O. The original position O is defined as a position where the axial center of the shaft 121 is located at the center of the opening 192a of the cover 192.

As shown in Figs. 1A and 1B, the metal piece 130 is a metal plate of circular ring shape that can move parallel to the insulating substrate 110 in accordance with the movement of the operation body 120. The metal piece 130 has an inner peripheral area 131 and an outer peripheral area 132. The inner peripheral area 131 of an L-shaped cross section is embedded in the attachment portion 122b of the slider 122 of the operation body 120. The outer peripheral area 132 is a circular plate continuing to the outer periphery of the inner peripheral area 131 as shown in Figs. 1A and 1B. The outer peripheral area 132 has an outer diameter that is smaller than the virtual circle drawn along the inner circumferences of the direction detection electrodes 141a to 144a, and it has an inner diameter that is larger than the outer diameter of the GND electrode 150. When the operation body 120 is located at the original position O, the outer peripheral area 132 is located at such a position so as to face and cover the movement detection electrode 140b (this position is hereinafter referred to as an initial position of the metal piece 130). When the metal piece 130 is at the initial position as shown in Figs. 1A and 3A, a planar distance R1 is substantially the same as a planer distance R2, where R1 is the planer distance between the outer circumference (outer end) of the outer peripheral area 132 and the inner circumferences (inner end) of the direction detection electrodes 141a to 144a, and R2 is the planer distance between the inner circumference of the outer peripheral area 132 and the outer circumference of the GND electrode 150. In this arrangement, when the outer peripheral area 132 moves from the initial position in Y, X, -Y and -X directions, the portions on Y, X, -Y and -X direction sides, respectively, of the outer peripheral area 132 overlap the direction detection electrodes 141a, 142a, 143a, 144a, respectively in plane position; and virtually simultaneously the portions on -Y, -X, Y and X direction sides, respectively, of the outer peripheral area 132 overlap the GND electrode 150 in plane position (see Fig. 3B). When the outer peripheral area 132 moves in the Y, -Y directions from the initial position, the outer peripheral area 132 also partially overlaps the direction detection electrodes 142a, 144a, respectively, and the movement detection electrode 140b. When the outer peripheral area 132 moves in the X, -X directions from the initial position, the outer peripheral area 132 also partially overlaps the direction detection electrodes 141a, 143a, respectively, and the movement detection electrode 140b.

As shown in Figs. 1A, 1B and Fig. 2, the origin return mechanism 160 has first and second sliders 161, 162 and first and second springs 163, 164. The first and second sliders 161, 162 are plates of plastic material arranged orthogonally to each other inside the housing body 191. Lengthwise ends of the first slider 161 are sandwiched between the bottom of the housing body 191 and the top plate of the cover 192 slidably in the Y and -Y directions. Lengthwise ends of the second slider 162 are sandwiched between the bottom of the housing body 191 and the top plate of the cover 192 slidably in the X and -X directions. In a central portion of the first slider 161, a substantially rectangular long hole 161a extends in the X and -X direction. In a central portion of the second slider 162, a substantially rectangular long hole 162a extends in the Y, -Y direction. The long holes 161a, 162a communicate with each other, through which the protrusion 122a of the slider 122 of the operation body 120 passes. The protrusion 122a abuts edges in the Y, -Y direction of the long hole 161a and edges in the X, -X direction of the long hole 162a, but the protrusion 122a is freely movable in the X, -X direction inside the long hole 161a and in the Y, -Y direction inside the long hole 162a. One of the ends of the first slider 161 is provided with a pair of projections 161b at spaced positions along the Y and - Y direction. One of the ends of the second slider 162 is provided with a pair of projections 162b at spaced positions along the X, -X direction.

As shown in Fig. 2, lower end portions of the first and second springs 163, 164 are contained in the spring receiving holes 191b of the housing body 191, and upper end portions thereof project from the spring receiving holes 191b. Opposite ends of the upper end portion of the first spring 163 abut the pair of projections 161b of the first slider 161, and opposite ends of the upper end portion of the second spring 164 abut the pair of projections 162b of the second slider 162. This allows the first and second springs 163, 164 to elastically hold the operation body 120 at the original position O via the first and second sliders 161, 162. When the first slider 161 moves in the Y (-Y) direction, the first spring 163 is compressed between the edges in the Y (-Y) direction of the spring receiving hole 191b and the projection 161b on the -Y (Y) direction side. When the second slider 162 moves in the X (-X) direction, the second spring 164 is compressed between the edge in the X (-X) direction of the spring containing hole 191b and the projection 162b on the -X (X) direction side. This is how the first spring 163 urges the first slider 161 in the -Y (Y) direction, the second spring 164 urges the second slider 162 in the -X (X) direction. The first and second sliders 161, 162 thus serve as intermediaries of the first and second springs 163, 164 for returning the operation body 120 to the original position O.

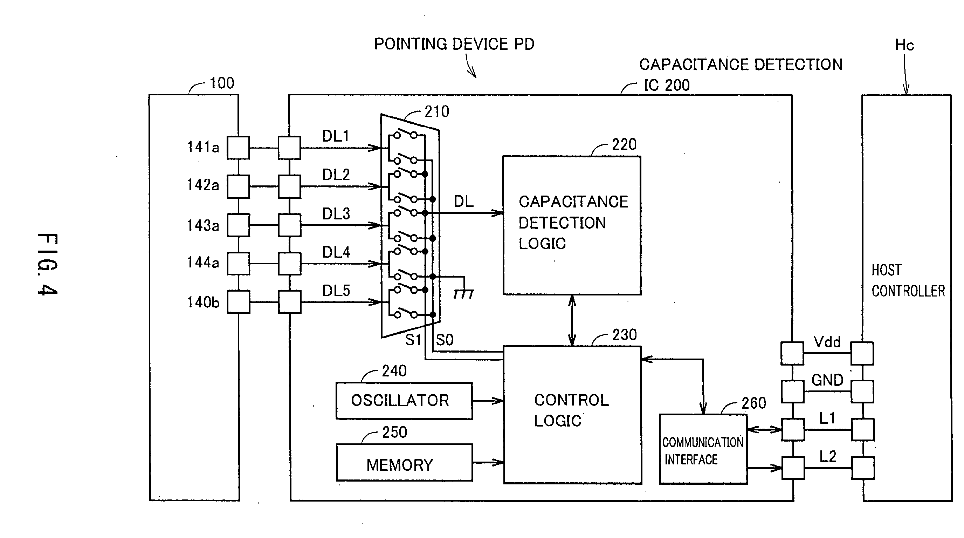

The capacitance detection IC 200 is mounted on a flexible substrate (refer to Fig. 2) provided continuously to the insulating substrate 110. As shown in Fig. 4, the capacitance detection IC 200 has a circuit configuration including a multiplexer 210 (corresponding to a switcher), a capacitance detection logic 220 (corresponding to a detector), a control logic 230 (corresponding to a controller), an oscillator 240, a memory 250, and a communication interface 260. The capacitance detection IC 200 is powered from the host controller HC through a Vdd line and a GND line, and it is mutually communicable with the host controller HC through communication lines L1, L2.

The multiplexer 210 is a signal selection circuit adapted to receive inputs through detection lines DL1, DL2, DL3, DL4, and DL5 connected to the direction detection electrode 141a to 144a and the movement detection electrode 140b, respectively. The multiplexer 210 is configured to select one of the detection lines DL1, DL2, DL3, DL4, and DL5 in accordance with a selection signal S1 and connect the selected detection line to a detection line DL, and to connect the remaining ones of the detection lines DL1, DL2, DL3, DL4, and DL5 to GND in accordance with a selection signal S0. In other words, the multiplexer 210 makes a selection from the direction detection electrodes 141a to 144a and the movement detection electrode 140b through making a selection from the detection lines DL1, DL2, DL3, DL4, and DL5. Signals S1 and S0 are inputted into the multiplexer 210 from the capacitance detection logic 220.

The capacitance detection logic 220 is a capacitance detection circuit that obtains a magnitude of capacitance between the detection electrode selected by the multiplexer 210 and the metal piece 130 by arithmetic operation, based on a magnitude of current flowing through the detection line DL, and outputs the result of the arithmetic operation to the control logic 230 as a signal.

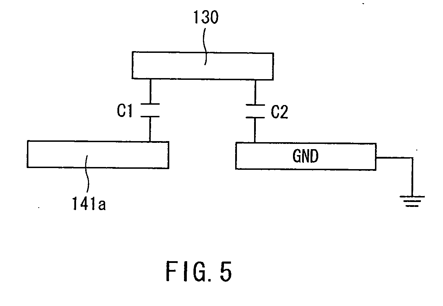

For example, when the multiplexer 210 selects the detection line DL1, a predetermined voltage is applied to the direction detection electrode 141a through the detection line DL1 only during an active time period TA. The magnitude of the current flowing through the detection line DL1 is converted into the magnitude of the capacitance between the direction detection electrode 141a and the metal piece 130 by the capacitance detection logic 220, and this data is outputted to the control logic 230. At the same time, the unselected detection lines DL2 to DL5 are connected to the GND. As a result, no detection electrode that is electrically floating exists in the vicinity of the direction detection electrode 141a connected to the selected detection line DL1, so that, as shown in Fig. 5, a potential difference occurs between the direction detection electrode 141a and the GND (the unselected direction detection electrodes 142a to 144a, the movement detection electrode 140b, and the GND electrode 150) via the metal piece 130. Consequently, a larger capacitance is obtained between the metal piece 130 and the direction detection electrode 141a. A capacitance C1 produced between the metal piece 130 and the direction detection electrode 141a and a capacitance C2 occurring between the metal piece 130 and the GND are assumed to be arranged in series, so that a synthetic capacitance C is expressed by the following mathematical expression 1. It is appreciated that C1 is proportional to a facing area between the direction detection electrode 141a and the metal piece 130, and that C2 is proportional to a facing area between the GND and the metal piece 130.

[Mathematical expression 1]

$$C = (C1 * C2) / (C1 + C2)$$

Similar process to the above is carried out also when one of the detection lines DL2 to DL4 is selected by the multiplexer 210. Moreover, when the detection line DL5 is selected by the multiplexer 210, a predetermined voltage is applied to the movement detection electrode 140b through the detection line DL5 only during the active time period TA. During this time period, the magnitude of the current flowing through the detection line DL5 is converted to the magnitude of the capacitance between the movement detection electrode 140b and the metal piece 130 by the capacitance detection logic 220, and this data is outputted to the control logic 230.

The control logic 230 is a control circuit with a CPU (Central Processing Unit) as the dominant constituent. The control logic 230 detects the presence or absence and the movement direction of the operation body 120 while controlling the multiplexer 210, the capacitance detection logic 220, the communication interface 260, etc. and outputs these detection results to the host controller HC. The control program used by the control logic 230 is stored on the memory 250 in advance. A basic clock is generated in the oscillator 240. The control logic 230 has an input/output port for connecting the communication interface 260 to mutually communicate with the host controller HC in a serial method.

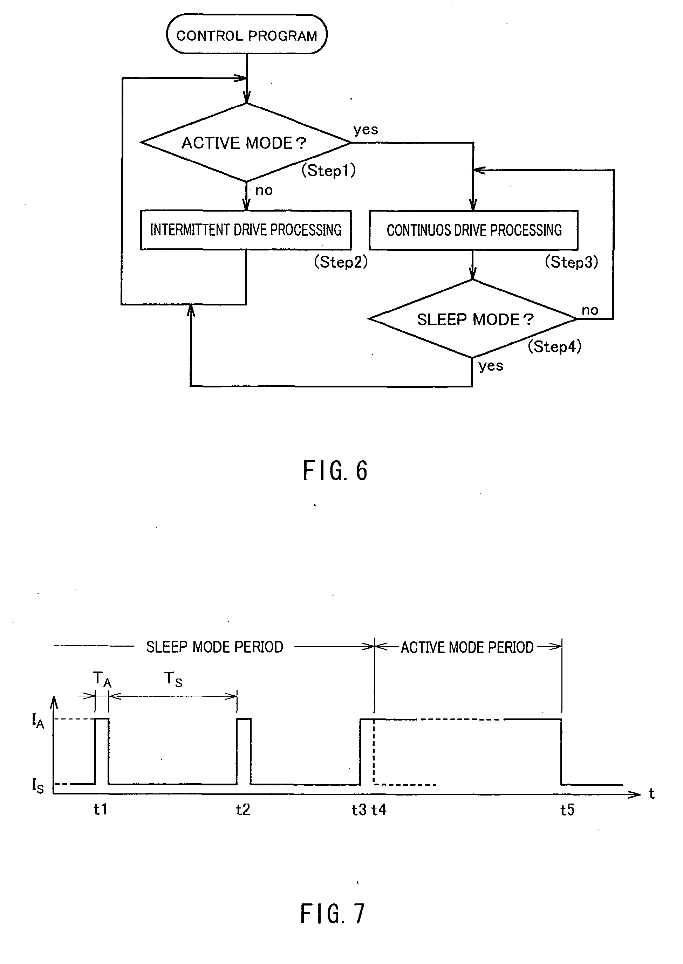

The control logic 230 is capable of intermittently detecting the presence or absence of movement of the operation body 120 in the sleep mode. When the detection result indicates movement of the operation body 120, the control logic 230 terminates the sleep mode and shifts to the active mode to continuously detect the movement direction of the operation body 120. Thereafter (after shifting to the active mode), the control logic 230 further has a modal shifting function from the sleep mode to the active mode if no change in the detected movement direction of the operation body 120 has been observed in a predetermined period. These functions are carried out using a control program as shown in Fig. 6.

First, the control logic 230 sets a detection cycle $T_s$ in a software timer in the sleep mode. After the detection cycle $T_s$ has elapsed, the control logic 230 outputs the selection signal S1 to make the multiplexer 210 select the detection line DL5, and in this state receives an inputted data on the magnitude of the capacitance outputted from the capacitance detection logic 220 (i.e. the data on the magnitude of the capacitance between the movement detection electrode 140b and the metal piece 130). The control logic 230 determines whether or not the data is below a predetermined first threshold value stored on memory 250, and if determined not to be below the first threshold value, the above processing is repeatedly performed (Step 1 and Step 2).

When the control logic 230 determines in the sleep mode that the data on the capacitance between the movement detection electrode 140b and the metal piece 130 is below the first threshold value (Step 1), the control logic 230 judges that the movement of the operation body 120 is detected, outputs the detection result to the host controller HC, and then outputs the selection signals S1, S0 to the multiplexer 210 in the following manner to terminate the sleep mode and shift to the active mode.

In the active mode (Step 3), the control logic 230 outputs the selection signal S1 to the multiplexer 210 and makes the multiplexer 210 sequentially select the detection lines DL1, DL2, DL3 and DL4 and sequentially connect the same to the capacitance detection logic 220. On the other hand, the control logic 230 outputs the selection signal S0 to the multiplexer 210 and makes the multiplexer 210 connect the unselected ones of the detection lines DL1, DL2, DL3, DL4, DL5 to the GND in accordance with the selection signal S1. For example, when the detection line DL1 is selected in accordance with the selection signal S1, the detection lines DL2, DL3, DL4 and DL5 are connected to the GND in accordance with the selection signal S0. When the detection line DL2 is selected in accordance with the selection signal S1, the detection lines DL1, DL3, DL4 and DL5 are connected to the GND in accordance with the selection signal S0.

Simultaneously, the control logic 230 sequentially receives input of the data indicating the magnitudes of the capacitances outputted from the capacitance detection logic 220 (the magnitude of the capacitance between the selected detection electrode 141a to 144a and the metal piece 130). Thereafter, the control logic 230 determines whether or not the inputted magnitude of the capacitance exceeds a predetermined second threshold value stored on the memory 250, and if determined that the magnitude exceeds the second threshold value, the control logic 230 judges that the change in the movement direction of the movement body 120 is detected and outputs the detection result to the host controller HC. For example, when the detection line DL1 is selected and it is determined that the magnitude of the capacitance exceeds the second threshold value, the control logic 230 judges that movement in the Y direction of the operation body 120 is detected as shown in Fig. 3B and outputs the detection result to the host controller HC. When another detection line DL2, DL3 or DL4 is selected and it is determined that the data of the capacitance exceeds the second threshold value, the control logic 230 judges that movement in the X, -Y, or -X direction, respectively, of the operation body 120 is detected, and the control logic 230 outputs the detection result to the host controller HC.

When the control logic 230 determines that the magnitude of the capacitance outputted from the capacitance detection logic 220 does not exceed the second threshold value, the control logic 230 judges that no change in the movement of the operation body 120 is observed, counts a non-changing time period (a period where no change is observed), and repeats the above processing (Step 3) for the active mode until the non-changing time period exceeds a predetermined period (Step 4).

When the control logic 230 determines that the above non-changing time period has exceeded the predetermined period, it judges that there is no change in the movement direction of the operation body 120 in the predetermined period, and terminates the active mode, and shifts to sleep mode. Also when the control logic 230 receive an instruction to terminate the active mode (external command) from the host controller HC, it terminates the active mode forcibly and shifts to the sleep mode. Thereafter, the control logic 230 repeats the processing for the sleep mode described above (Step 1 and Step 2).

The control logic 230 also outputs a contact signal of the press switch 170 to the host controller HC.

The pointing device PD having the above configuration operates in the following manner.

First, in the sleep mode period, the presence or absence of the movement of the operation body 120 is intermittently detected at every detection cycle $T_s$. That is, when the operation body 120 is not operated and remains at the original position O, the magnitude of the capacitance between the metal piece 130 and the movement detection electrode 140b does not change, which is detected as the absence of the movement of the operation body 120, so that the sleep mode is continued. Thereafter, when the operation body 120 is operated to move off the original position O, reducing an overlapping area between the metal piece 130 and the movement detection electrode 140b, and accordingly reducing the capacitance between the metal piece 130 and the movement detection electrode 140b. It is thus detected that the movement of the operation body 120 is present, and then the sleep mode is terminated and shifted to the active mode.

In the active mode period, the movement direction of the operation body 120 is continuously detected. For example, when the operation body 120 is operated in the Y direction, as shown in Fig. 3B, the metal piece 130 overlaps the direction detection electrode 141a and the GND electrode 150 in plane position virtually simultaneously, and it also partially overlaps the direction detection electrodes 142a, 144a and the movement detection electrode 140b. This increases an overlapping area between the metal piece 130 and the direction detection electrode 141a in plane position, and accordingly increases the capacitance between the metal piece 130 and the direction detection electrode 141a (refer to Fig. 3). It is thus detected that the operation body 120 has moved in the Y direction. The same holds true for operations of the operation body 120 in the X direction, -Y direction, or -X direction, where the capacitance between the metal piece 130 and the direction detection electrode 142a, 143a, or 144a increases, so that it is detected that the operation body 120 has moved in the X direction, the -Y direction, or the -X direction, respectively.

Thereafter (after the shift to the active mode), when the operation body 120 is not operated and there is no change in the detected movement direction of the operation body 120, or when the pointing device PD receives an instruction (external command) from the host controller HC to terminate the active mode, the active mode is terminated and shifted to the sleep mode.

Fig. 7 illustrates changes in power consumption of the pointing device PD. Particularly, the figure illustrates a case by way of example in which movement of the operation body 120 is not detected at times t1 and t2, movement of the operation body 120 is detected at time t3, the mode shifts to the active mode at time t4 to continuously detect the movement direction of the operation body 120, and the mode shifts to the sleep mode at time t5.

A mathematical expression 2 indicated below expresses an average current consumption $I_{AVE}$ in the sleep mode period. Where $I_A$ is a current consumption in a period when detecting the presence or absence and the movement direction of the operation body 120 with voltage applied to the movement detection electrode 140b or one of the direction detection electrodes 141a to 144a, and $I_s$ is a current consumption in the period when not detecting the presence or absence or the movement direction of the operation body 120 with no voltage applied to the movement detection electrode 140b.

[Mathematical expression 2]

$$I_{AVE} = \frac{(I_A \times T_A + I_s \times T_s)}{(T_A + T_s)}$$

It is clear from the mathematical expression 2 that setting the operation period $T_A$ at a smaller value will reduce the average current consumption $I_{AVE}$ in the sleep mode period.

The above-described pointing device PD is advantageously minimized in average current consumption for all the time periods including the sleep mode period and the active mode period because of the following outstanding features: (1) the movement detection electrode 140b provided in the pointing device PD to detect the presence or absence of the movement of the operation body 120; (2) intermittent detection in the sleep mode period of the presence/ absence of movement of the operation body 120; and (3) the mode shift to the sleep mode at a point in the active mode period when the detection of the movement direction of the operation body 120 becomes unnecessary. The reduced average current consumption contributes to reduction in power consumption of the pointing device PD. The pointing device PD also requires significantly shortened time for detecting the presence or absence of movement of the operation body 120.

In addition, when the outer peripheral area 132 of the metal piece 130 moves off from the initial position to the Y, X, -Y, and -X directions, the portions on the Y, X, -Y, and -X direction sides, respectively, of the outer peripheral area 132 overlap the direction detection electrodes 141a, 142a, 143a, 144a, , respectively, and virtually simultaneously the portions on the -Y, -X, Y, and X direction sides of the outer peripheral area 132 overlap the GND electrode 150 in plane position, producing capacitance between the outer peripheral area 132 of the metal piece 130 and the direction detection electrodes 141a, 142a, 143a, 144a, respectively. Simultaneously, the multiplexer 210 selects one of the direction detection electrodes 141a to 144a in accordance with the selection signal S1, while the direction detection electrodes not selected in accordance with the selection signal S1 and the movement detection electrode 140b are connected to the GND in accordance with the selection signal S0. The potential difference thus occurs via the metal piece 130 between the direction detection electrode selected and the GND (the unselected direction detection electrodes and the GND electrode 150), increasing the capacitance between the selected detection electrode and the metal piece 130. As a result, it is possible to improve detection accuracy of the movement of the operation body 120, contributing to enhanced performance of the pointing device.

Furthermore, as the insulating layer 180 protects the movement detection electrode 140b, the direction detection electrodes 141a to 144a, the GND electrode 150, and the snap plate 171, mechanical strength is increased, and the capacitance between the metal piece 130, and the movement detection electrode 140b or the direction detection electrodes 141a to 144a becomes larger, thereby enhancing the detection accuracy. Moreover, it is easy to fix the snap plate 171 because it is sandwiched and fixed by the insulating layer 180. Thus, these features count significantly in realizing high performance and low cost of the 0054]

The multidirectional input device according to the present invention is not limited to the above embodiment. The device may be modified in design within the scope of claims as detailed in detail below.

The base may or may not be the insulating substrate 110 as in the above embodiment. The base is only required to have an insulated surface and allow the first and second detection electrodes to be provided thereon. For example, the base may be a rigid substrate or a bottom of a housing having an insulated inner bottom surface.

The operation portion may be the sliding operation body 120 that moves parallel along the insulating substrate 110 as in the above embodiment. Alternatively it may be of a tiltable, swingable or other type. That is, the above-described multidirectional input device is applicable not only to capacitive pointing devices but also capacitive joysticks and the like. The operation portion may or may not be adapted for press operation. If the operation portion is unpressable, the press switch 170 and the flange 121a may be omitted. Alternatively, the operation portion may be configured to allow pressing operation input only at the original position O. The flange 121a is unnecessary also in this case. The original position O is not limited to the position where the axial center of the shaft 121 is located at the center of the opening 192a of the cover 192, but the original position may be set at any position.

The movable metal member may be the ring-shaped metal piece 130 having the inner peripheral area 131 and the outer peripheral area 132 as in the above embodiment. The movable metal member may be in any form as long as it is of annular shape, faces the second detection electrode at the initial position, and is movable in accordance with the movement of the operation portion. However, it is required that the planar distance R1 and the planar distance R2 are substantially the same, where R1 is a planar distance between an outer end of the movable metal member located at the initial position and inner ends of the first detection electrodes, and R2 is a planar distance between an inner end of the movable metal member located at the initial position and an outer end of the GND electrode. The movable metal member may be attached to the operation portion via a coupling mechanism.

The first detection electrodes are not limited to circular-arc direction detection electrodes 141a to 144a as in the above embodiment, but they only need to be spacedly arranged in an annular shape on the surface of the base. They may be modified in design, such as in shape and number. For example, the first detection electrodes may be arranged in a polygonal shape on the surface of the base. The second detection electrode may be the movement detection electrode 140b of circular ring shape as in the above embodiment, or it may be modified in design as long as it is an annular electrode, disposed concentrically with the first detection electrodes and inside the first detection electrodes on the surface of the base. The GND electrode may be of circular ring shape or may be in any other shape as long as it is disposed concentrically with the second detection electrode and inside the second detection electrode on the surface of the base. The term "annular" herein means not only a circular ring shape but also any polygonal ring shape such as a square.

The detection device may be configured to directly measure capacitances between the movable metal member and the first and/or second detection electrodes, and detect the movement direction and/or presence or absence of movement of the operation portion based on the measurement results.

The switcher of the above embodiment selects one direction detection electrode of the direction detection electrodes 141a to 144a and the movement detection electrode 140b in accordance with the selection signal S1, and the unselected direction detection electrodes and the movement detection electrode 140b are connected to the GND in accordance with the selection signal S0. However, the switcher may be configured to select one direction detection electrode of the first and second detection electrodes, or to select either the first detection electrodes or the second detection electrode. In the latter case, the switcher may select the second detection electrode in the sleep mode and selects all the first direction detection electrodes in the active mode, while the detection device may preferably be configured to simultaneously measure the capacitances between the movable metal member and the plurality of first direction detection electrodes with a plurality of measurement circuits.

Reference Signs List

PD pointing device (multidirectional input device)

100 input unit

110 insulating substrate (base)
120 operation body (operation portion)
130 metal piece (movable metal member)
141a to 144a direction detection electrode (first detection electrode)
140b movement detection electrode (second detection electrode)
150 GND electrode
160 origin return mechanism
170 press switch

171 snap plate
172, 173 contact electrode

180 insulating layer
190 case

200 capacitance detection IC (detection device)

210 multiplexer (switcher)
220 capacitance detection logic (detector)
230 control logic (controller)
240 oscillator
250 memory
260 communication interface

HC host controller

## Claims

1. A multidirectional input device (PD) comprising:

   a base (110) having a surface;
   a plurality of first detection electrodes (141a-144a), spacedly arranged in an annular shape on the surface of the base;

a second detection electrode (140b) of annular shape, disposed concentrically with the first detection electrodes and inside the first detection electrodes on the surface of the base;

a GND electrode (150), disposed concentrically with the second detection electrode and inside the second detection electrode on the surface of the base;

an operation portion (120), facing the base and being movable in multiple directions from a predetermined original position (O);

a movable metal member (130) of annular shape, movable from an initial position, where the movable metal member faces the second detection electrode, in accordance with movement of the operation portion; and

a detection device (200), adapted to detect presence or absence of movement of the operation portion through measurement of capacitance between the movable metal member and the second detection electrode, and adapted to detect a movement direction of the operation portion through measurements of capacitances between the movable metal member and the respective first detection electrodes, wherein

a distance R1 and a distance R2 are substantially the same, where R1 is a planar distance between an outer edge of the movable metal member located at the initial position and inner edges of the first detection electrodes, and R2 is a planar distance between an inner edge of the movable metal member located at the initial position and an outer edge of the GND electrode.

2. The multidirectional input device according to claim 1, wherein the detection device (200) includes:

a switcher (210) that is operable to select one detection electrode from the first and second detection electrodes (141a-144a, 140b);

a detector (220) that is operable to detect the magnitude of the capacitance between the detection electrode selected by the switcher and the movable metal member (130); and

a controller (230) that is operable to control the switcher to switch between a sleep mode to detect presence or absence of the movement of the operation portion and an active mode to detect the movement direction of the operation portion, wherein

the controller is operable to control the switcher so as to select the second detection electrode and thereby set the sleep mode, and in this state, the controller detects the presence or absence of movement of the operation portion based on output from the detector, and thereafter, upon detection of movement of the operation portion (120), the controller controls the switcher so as to sequentially select the first detection electrodes and thereby switch the sleep mode to the active mode, and in this state, the controller detects the movement direction of the operation portion based on output of the detector, and thereafter, when detecting no change in the movement direction of the operation portion for a predetermined period, the controller controls the switcher so as to select the second detection electrode and thereby switch the active mode to the sleep mode.

3. The multidirectional input device according to claim 1, wherein the detection device (200) includes:

a switcher (210) that selects either the first electrodes (141a-144a) or the second detection electrode (140b);

a detector (220) that is operable to detect the magnitude of the capacitance between the detection electrode or electrodes selected by the switcher and the movable metal member (130); and

a controller (230) that is operable to control the switcher to switch between a sleep mode to detect the presence or absence of the movement of the operation portion and an active mode to detect the movement direction of the operation portion, wherein

the controller is operable to control the switcher so as to select the second detection electrode and thereby set the sleep mode, and in this state, the controller detects the presence or absence of movement of the operation portion based on output from the detector, and thereafter, upon detection of movement of the operation portion, the controller controls the switcher so as to select the first detection electrodes and thereby switches the sleep mode to the active mode, and in this state, the controller detects the movement direction of the operation portion based on output of the detector, and thereafter, when detecting no change in the movement direction of the operation portion for a predetermined period, the controller controls the switcher so as to select the second detection electrode and thereby switch the active mode to the sleep mode.

4. The multidirectional input device according to claim 2 or 3, wherein the switcher (210) connects the selected detection electrode or electrodes to the detector and the unselected detection electrode or electrodes to GND.

5. The multidirectional input device according to any one of claims 2 to 4, wherein upon receiving an external command in the active mode, the detection device (200) controls the switcher so as to select the second detection electrode (140b) and thereby switch to the sleep mode.

6. The multidirectional input device according to any one of claims 1 to 5, further comprising an insulating layer (180) provided on the surface of the base so as to cover at least the first and second detection electrodes (141a-144a), 140b), wherein the movable metal member is partly contactable with an outer surface of the insulating layer.

7. The multidirectional input device according to claim 6, further comprising a press switch (170) that is operable to detect a press of the operation portion, the press switch comprising:

   a dome-like snap plate (171), fixedly sandwiched between the base and the insulating layer and adapted to be turned inside out when the operation portion is pressed; and
   contact electrodes (172, 173) disposed on the surface of the base, and closed by the snap plate turned inside out.

8. The multidirectional input device according to claim 7, wherein the operation portion (120) comprises:

   a shaft (121) having an end, the end being adapted to face the press switch (170) at the original position, and
   an annular flange (121a) provided around a circumferential surface of the end of the shaft.

FIG. 1A

FIG. 1B

EP 2 428 876 A2

FIG. 2

14

FIG. 3A

FIG. 3B

FIG. 4

130

C1

C2

141a

GND

FIG. 5

CONTROL PROGRAM

ACTIVE MODE ? — yes
(Step1)

no

INTERMITTENT DRIVE PROCESSING
(Step2)

CONTINUOS DRIVE PROCESSING
(Step3)

SLEEP MODE ? — no
(Step4)

yes

FIG. 6

SLEEP MODE PERIOD — ACTIVE MODE PERIOD

$T_A$ $T_S$

$I_A$

$I_S$

t1    t2    t3 t4    t5    t

FIG. 7

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001325858 A